(19) Europäisches Patentamt / European Patent Office / Office européen des brevets

(11) **EP 2 223 581 B1**

(12) **FASCICULE DE BREVET EUROPEEN**

(45) Date de publication et mention de la délivrance du brevet:
**17.09.2014 Bulletin 2014/38**

(21) Numéro de dépôt: **08862410.1**

(22) Date de dépôt: **29.10.2008**

(51) Int Cl.:
*H05K 3/46* *(2006.01)*   *H01L 21/768* *(2006.01)*
*H05K 3/40* *(2006.01)*   *H05K 3/00* *(2006.01)*

(86) Numéro de dépôt international:
**PCT/FR2008/051947**

(87) Numéro de publication internationale:
**WO 2009/077684 (25.06.2009 Gazette 2009/26)**

(54) **PROCÉDÉ DE RÉALISATION D'UNE INTERCONNEXION ÉLECTRIQUE ENTRE DEUX COUCHES CONDUCTRICES**

VERFAHREN ZUR HERSTELLUNG EINER ELEKTRISCHEN VERBINDUNG ZWISCHEN ZWEI LEITFÄHIGEN SCHICHTEN

METHOD FOR MAKING AN ELECTRIC INTERCONNECTION BETWEEN TWO CONDUCTING LAYERS

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **17.12.2007   FR 0759881**

(43) Date de publication de la demande:
**01.09.2010 Bulletin 2010/35**

(73) Titulaire: **Commissariat à l'Énergie Atomique et aux Énergies Alternatives**
**75015 Paris (FR)**

(72) Inventeurs:
• **VERILHAC, Jean-Marie**
  **F-38000 Grenoble (FR)**
• **BABLET, Jacqueline**
  **F-38450 Le Gua (FR)**
• **BORY, Cécile**
  **F-38120 Le Fontanil (FR)**

(74) Mandataire: **Vuillermoz, Bruno et al**
**Cabinet Laurent & Charras**
**"Le Contemporain"**
**50, Chemin de la Bruyère**
**69574 Dardilly Cédex (FR)**

(56) Documents cités:
**EP-A- 0 967 624**       **US-A- 5 840 417**
**US-A1- 2005 277 279**   **US-A1- 2006 045 962**
**US-A1- 2006 292 769**

**Description**

**DOMAINE DE L'INVENTION**

La présente invention a trait à la réalisation d'une interconnexion électrique entre deux couches conductrices séparées par au moins une couche isolante ou semi-conductrice, plus particulièrement mise en oeuvre dans la réalisation de circuits électroniques.

Elle s'applique notamment lorsque le dépôt de la couche séparatrice en matériau isolant ou semi-conducteur est réalisée par voie humide.

On parle classiquement de vias qui, de manière connue, constitue un chemin conducteur à travers une couche isolante.

La présente invention s'applique tout particulièrement à la réalisation de transistors, pour lequel le via en question constitue le chemin conducteur à travers l'isolant de grille et le semi-conducteur.

Elle s'applique également de manière générale pour la réalisation de vias dans le cadre de l'électronique utilisant des matériaux organiques et inorganiques et/ou des matériaux hybrides organiques-inorganiques, notamment déposés par voie humide.

**ETAT ANTERIEUR DE LA TECHNIQUE**

On distingue classiquement deux procédés de réalisation de vias, plus généralement mis en oeuvre pour la réalisation de transistors à effet de champ.

Une première méthode dite « méthode soustractive », consiste à réaliser de tels vias par attaque physique ou chimique de la couche ou des couches en matériau isolant ou semi-conducteur à traverser. Cette attaque est réalisée par ablation laser, par jet de solvant, par embossage, voire par utilisation d'une couche diélectrique photoréticulable sous l'action d'un rayonnement ultraviolet. Elle est donc nécessairement réalisée après dépôt de la couche isolante ou semi-conductrice.

En fonction de l'architecture utilisée pour la réalisation de transistors à effet de champ, et notamment type « bottom-gate » (grille basse) ou « top-gate » (grille haute), cette étape d'attaque intervient en fin de processus ou en milieu de processus.

Une telle attaque est susceptible de générer des pollutions, notamment constituées de débris dus au tir laser, de résidus de solvant, outre de dégradations de la couche semi-conductrice lors de la soumission de celle-ci à rayonnements ultraviolets. Or il s'avère que de telles pollutions sont particulièrement critiques lorsqu'elles touchent l'interface semi-conducteur/isolant, et peuvent fortement dégrader les performances électriques des transistors. De plus, l'accumulation d'étapes en fin de processus augmente le risque de détériorer les couches déjà déposées, de telles détériorations se traduisant notamment par le décollement des couches après tir laser, voire la dissolution involontaire de partie desdites couches lorsque les vias sont réalisés par jets de solvants, etc...

Une deuxième méthode, dite « méthode sélective », consiste à réaliser le dépôt sélectif de la couche d'isolant ou de semi-conducteur. Cette méthode consiste à déposer localement la couche isolante ou semi-conductrice en évitant certaines zones. Dans les zones vierges, c'est-à-dire dépourvues de matériau isolant ou semi-conducteur, le premier niveau conducteur, c'est-à-dire la couche du matériau conducteur inférieure, est à nu. Lesdites zones vierges sont donc destinées à faire office de vias. Cette méthode présente l'avantage de ne pas engendrer de pollution du type de celles décrites dans la méthode précédente.

Afin de réaliser un tel dépôt localisé, on peut utiliser les techniques d'impression de type flexographie, héliographie, jet d'encre, sérigraphie, etc... Cependant, l'expérience démontre que l'utilisation de certains matériaux diélectriques ou semi-conducteurs est difficilement formulable dans une encre adaptée aux techniques d'impression. Les plus simples demeurent le dépôt pleine couche par les technologies bien connues par l'homme du métier sous les expressions anglo-saxonnes « spin coating » (tournette), « dip-coating » (trempage), « spray coating » (pulvérisation), etc... De plus, ces méthodes de dépôt ne permettent pas une résolution spatiale suffisante dans un grand nombre d'applications.

Le document US2005/277279 décrit la fixation d'un semi-conducteur avec un autre élément par des éléments d'interconnexion.

L'objectif visé par la présente invention est de réaliser de tels vias d'interconnexion en s'affranchissant des inconvénients liés aux techniques aujourd'hui disponibles et brièvement rappelées précédemment.

**DESCRIPTION SUCCINCTE DE L'INVENTION**

L'invention vise donc un procédé pour réaliser une interconnexion électrique entre deux couches conductrices séparées par au moins une couche isolante ou semi-conductrice, dénommée couche séparatrice, tel que défini dans les revendications indépendantes.

Ce procédé consiste à réaliser un plot, préalablement à la réalisation ou au dépôt de la couche séparatrice, s'étendant au moins entre la couche conductrice inférieure et le voisinage de la couche conductrice supérieure, plot dont le matériau constitutif, à tout le moins de sa surface externe, est choisi pour présenter une tension de surface telle à l'état solide, que le rapport des tensions de surface, respectivement dudit matériau à l'état solide et de la couche séparatrice à l'état liquide est inférieur ou égal à 7.

Autrement dit, la nature du matériau constitutif du plot est telle que celui-ci présente des propriétés de non mouillabilité vis-à-vis de la couche séparatrice réalisée en matériau isolant ou semi-conducteur.

Ce plot est, comme déjà dit, réalisé avant dépôt de la couche séparatrice, mais aussi de la couche conductrice supérieure.

En d'autres termes, l'invention consiste à mettre en oeuvre un plot, conducteur ou non conducteur, et à jouer sur sa nature et/ou sur sa forme ou sur son facteur de forme, propre à lui permettre d'assurer sa fonction de conduction électrique, soit en raison de sa nature, soit en raison du dépôt subséquent de la couche conductrice supérieure, susceptible de venir combler la zone de non mouillabilité laissée vierge de tout matériau isolant ou semi-conducteur.

L'aptitude au mouillage d'un corps solide par une solution peut être caractérisée par la différence des tensions de surface respectives $\gamma$ des matériaux qui les composent, traditionnellement exprimées en dynes/cm ou en mN/cm.

Ainsi, pour une surface plane (c'est-à-dire sans relief) et horizontale), un mauvais mouillage d'une solution sur un corps solide correspond à un rapport de tensions de surface tel que $\dfrac{\gamma_{solide}}{\gamma_{liquide}} \leq 1$.

Dans le cadre de l'invention, la surface du corps solide (le plot) n'est pas horizontale, le démouillage recherché s'effectuant le long de ses parois latérales principalement. Ce faisant, les forces de gravité qui s'exercent sur le liquide viennent s'opposer aux forces de mouillage. Il s'en suit que le démouillage peut apparaître pour un rapport des tensions de surface répondant à la relation :

$$\frac{\gamma_{solide}}{\gamma_{liquide}} \geq 1$$

Après analyse et recherche, il est apparu que le caractère démouillant ou non mouillant recherché pour le plot était satisfaisant, dès lors que le rapport des tensions de surface répond à la relation :

$$\frac{\gamma_{solide}}{\gamma_{liquide}} \leq 7$$

Aussi l'invention vise-t'elle la mise en oeuvre de plot répondant à cette relation.

Avantageusement, on choisira un plot, de telle sorte que ce rapport des tensions de surface satisfait à la relation :

$$\frac{\gamma_{solide}}{\gamma_{liquide}} \leq 1$$

Selon un exemple, ne faisant pas partie de l'invention, le plot est réalisé en un matériau conducteur et est déposé sur la couche conductrice inférieure, par exemple par technologie jet d'encre ou par sérigraphie.

Selon un premier mode de réalisation de l'invention, le plot est réalisé en un matériau conducteur et est réalisé par déformation de la première couche conductrice ou couche conductrice inférieure.

Afin de garantir un recouvrement non total de la surface du plot lors du dépôt de la couche séparatrice de matériau isolant ou semi-conducteur, la hauteur dudit plot est avantageusement supérieure à l'épaisseur de ladite couche isolante ou semi-conductrice.

Cependant, il peut être envisagé de mettre en oeuvre un plot, dont la hauteur est inférieure à l'épaisseur de la couche séparatrice, notamment si le matériau constitutif de cette dernière est très peu mouillable. Ceci est notamment possible si les matériaux respectifs choisis répondent à la relation

$$\frac{\gamma_{solide}}{\gamma_{liquide}} \leq 1$$

De plus, l'inclinaison de l'orientation des flancs du plot a une influence sur la non mouillabilité de la couche isolante ou semi-conductrice à ce niveau. Typiquement, l'inclinaison des flancs et notamment la valeur de l'angle $\alpha$ entre l'horizontale et les flancs, est avantageusement comprise entre 45 et 135°.

Les formes envisageables pour le plot peuvent être de différentes natures, notamment conique, tronconique, cylindrique, sphérique, parallélépipédique.

Selon un autre exemple, ne faisant pas partie de l'invention, le plot peut également résulter de la déformation du substrat sur lequel est déposée la première couche en matériau conducteur et du dépôt subséquent de la première couche conductrice venant recouvrir intégralement ledit substrat ainsi que sa déformation.

Dans le même ordre d'idée, le plot peut être ajouté sur le substrat avant le dépôt de la première couche conductrice.

Selon une autre forme de réalisation de l'invention, le plot peut être réalisé en un matériau isolant définissant à sa périphérie une zone non mouillable pour le matériau semi-conducteur ou isolant déposé subséquemment à la première couche conductrice. Selon ce mode de réalisation, la conduction électrique entre la couche conductrice inférieure et la couche conductrice supérieure résulte du dépôt de ladite couche conductrice supérieure, venant alors combler la zone non mouillante définie précédemment autour du plot.

**BREVE DESCRIPTION DES DESSINS**

La manière dont l'invention peut être réalisée et les avantages qui en découlent ressortiront mieux des exemples de réalisation qui suivent, donnés à titre indicatif et non limitatif, à l'appui des figures annexées.

La figure 1 est une représentation schématique du principe sous-tendant la présente invention.

La figure 2 est une représentation schématique visant à illustrer le mécanisme de démouillage de la couche isolante sur la surface du plot.

La figure 3 illustre différentes formes possibles du plot conforme à l'invention.

La figure 4 est une illustration schématique d'un mode de réalisation de l'invention à partir d'un plot réalisé directement sur le substrat.

Les figures 5a à 5b illustrent le principe de réalisation d'un plot en un matériau non conducteur.

La figure 6 est une vue schématique illustrant la mise en oeuvre d'un plot présentant un angle $\alpha$ inférieur à 90°.

La figure 7 est une vue schématique visant à illustrer le « coffee stain » effet, susceptible d'être utilisé dans le cadre de l'invention.

## MODES DE REALISATION DE L'INVENTION

Comme on l'aura compris, la présente invention propose deux modes possibles pour réaliser un via d'interconnexion de deux couches conductrices **2, 5**, séparées par une couche isolante ou semi-conductrice **4.**

Selon l'invention, la réalisation de ce via passe par la mise en oeuvre d'un plot **3,** rapporté sur la couche conductrice inférieure **2** ou directement sur le substrat **1,** sur lequel est déposé ladite couche conductrice inférieure, ou émanant de cette couche conductrice inférieure.

En fonction de la nature conductrice ou non conductrice du plot initial 3, différentes méthodes peuvent être envisagées.

Selon une première méthode visant à réaliser un plot directement conducteur, c'est à dire dont la nature du matériau qui le constitue est conducteur, et par exemple réalisé en Au, Cu, Ag ou en polymères conducteurs tels que le PDOT-PSS (poly(3,4-ethylenedioxythiphene) polystyrenesulfonate), on modifie la géométrie de la première couche conductrice inférieure **2.**

Cette couche **2** est classiquement déposée sur un substrat **1** de toute nature, notamment isolante, ou éventuellement semi-conductrice. Ladite couche **2** est par exemple réalisée en or, platine, cuivre, nickel, aluminium, etc. et le substrat **1** par exemple en matière plastique.

Selon l'invention, la couche **2** est déformée notamment par attaque d'un rayonnement laser. La couche conductrice **2** et/ou son support **1,** peut ainsi absorber tout ou partie du rayonnement laser pulsé ou continu. Une ou plusieurs de ces couches peut ainsi être ablatée ou fondue, créant de la sorte une déformation au moins de la couche conductrice **2.** Plus spécifiquement, la topologie de la couche métallique conductrice **2** est modifiée à la frontière du tir laser. Plus particulièrement, la couche conductrice **2** tend à se décoller du support **1** au niveau des bords du tir laser. Ce décollement peut ainsi faire office de plot conducteur pour la réalisation des vias selon l'invention. La forme de la déformation ainsi engendrée va dépendre de la forme du spot laser, circulaire ou linéaire, de sa puissance, de sa durée, du nombre de pulses (dans le cadre de la mise en oeuvre d'un laser pulsé), de l'interaction de sa longueur d'onde avec les couches déformables et des propriétés mécaniques, notamment de la couche conductrice à déformer, et notamment de sa ductilité et de son épaisseur.

On peut ainsi mettre en oeuvre des lasers de type Excimer (longueur d'onde 308 nm) ou autre longueur d'onde, ou laser YAG, voire laser $CO_2$.

La déformation en résultant va ainsi empêcher le mouillage.

Selon une variante de ce procédé de l'invention, on peut également procéder à un embossage ou à un micro-embossage pour déformer la première couche conductrice **2** et ainsi réaliser le plot. Cette déformation peut altérer soit directement la couche conductrice **2,** soit l'ensemble constitué par la couche conductrice **2** et le substrat **1.**

Quel que soit le mode de déformation de la couche conductrice inférieure **2** mise en oeuvre, il se crée une excroissance par rapport au plan général dans lequel est située la couche conductrice **2,** dont on assure une hauteur suffisante pour être, dans l'exemple décrit, supérieure à l'épaisseur de la couche isolante **4** destinée à recouvrir la couche conductrice inférieure **2** et ainsi assurer la conduction électrique avec la couche conductrice supérieure **5** et ce, conformément à l'invention.

La déformation de cette couche conductrice inférieure peut également résulter d'une attaque mécanique « scratching », d'une attaque chimique, d'une attaque électrique (électroérosion), d'une attaque thermique, d'une attaque magnétique, voire par plusieurs de ces méthodes couplées entre elles.

Cette ou ces attaques induisent la formation de surépaisseurs à la périphérie du lieu de l'attaque. C'est le phénomène qui est mis à profit dans le cadre de l'invention.

Lorsque le plot **3** est ainsi constitué, on procède au dépôt de la couche isolante ou semi-conductrice **4.** Une telle couche isolante est par exemple constituée d'un polymère tel que le PMMA, le polyvinylphénol, les polyoléfines, les polysulfones, le polyimide.

Quand elle est réalisée en un matériau semiconducteur ou semi-isolant, elle peut être alors en pentacene, en polythiophènes, en polytriarylamines.

Compte tenu de la forme du plot, décrite ci-après plus en détail, on aboutit à un démouillage partiel du plot.

Ce démouillage résulte tout d'abord de la gravité, qui tend à faire s'écouler le matériau isolant ou semi-conducteur en solution constitutif de la couche **4** (lorsque le solvant n'est pas encore évaporé) le long des flancs du plot, ce qui tend à diminuer l'épaisseur de la couche de matériau isolant ou semi-conducteur au niveau des flancs.

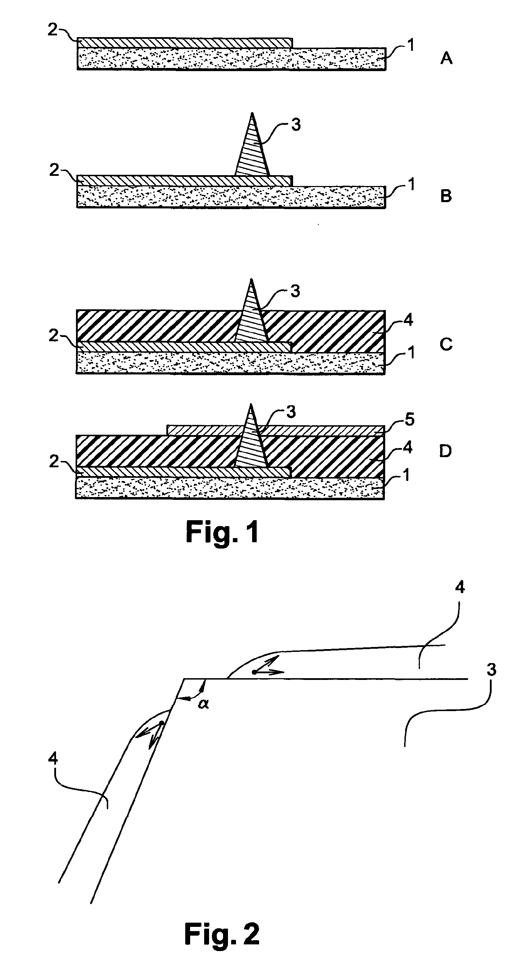

En outre, ce démouillage partiel du plot résulte des phénomènes de tension de surface apparaissant au niveau de l'angle α formé par la surface supérieure du plot et le ou les flancs du plot, et tel que par exemple illustré au sein de la figure 2.

Ainsi, un plot de nature métallique présente typiquement une tension de surface voisine de γ métal ≈ 50 dynes/cm (à température ambiante et sous pression atmosphérique). La solution constitutive de la couche séparatrice présente quant à elle une tension de surface typique γ liquide ≈ 10 à 20 dynes/cm.

On relève dès lors que la condition visée par l'invention est bien satisfaite, puisque selon ces données,

on aboutit à $\dfrac{\gamma_{métal}}{\gamma_{liquide}} \approx 2{,}5 \text{ à } 5$.

On observe ainsi que pour optimiser le démouillage, l'angle α est avantageusement choisi compris entre 45 et 135°.

Ainsi, la quantité de liquide constitutif de la couche isolante ou semi-conductrice tend à se minimiser au maximum au niveau de la surface de contact avec le plot. Ce phénomène dépend entre autres de la viscosité de la solution du matériau isolant ou semi-conducteur et de l'angle de contact entre la solution et la surface.

Afin de garantir un recouvrement partiel de la surface du plot, et plus particulièrement afin de s'assurer que la surface supérieure du plot, c'est-à-dire de la surface du plot destinée à se trouver au dessus de la couche de matériau isolante ou semi-conductrice **4** après dépôt de celle-ci, et comme déjà dit, on fait en sorte que la hauteur du plot soit supérieure à l'épaisseur de la couche isolante ou semi-conductrice **4**.

Cependant, dans l'hypothèse où la relation

$\dfrac{\gamma_{plot}}{\gamma_{liquide}} \leq 1$ est vérifiée, la hauteur du plot peut être inférieure à l'épaisseur de la couche séparatrice **4**.

Enfin, plus la surface de la base du plot (interface plot/couche inférieure) est petite, plus la non-mouillabilité du plot est importante. Ceci permet de disposer d'une plus grande surface de contact entre les deux couches conductrices.

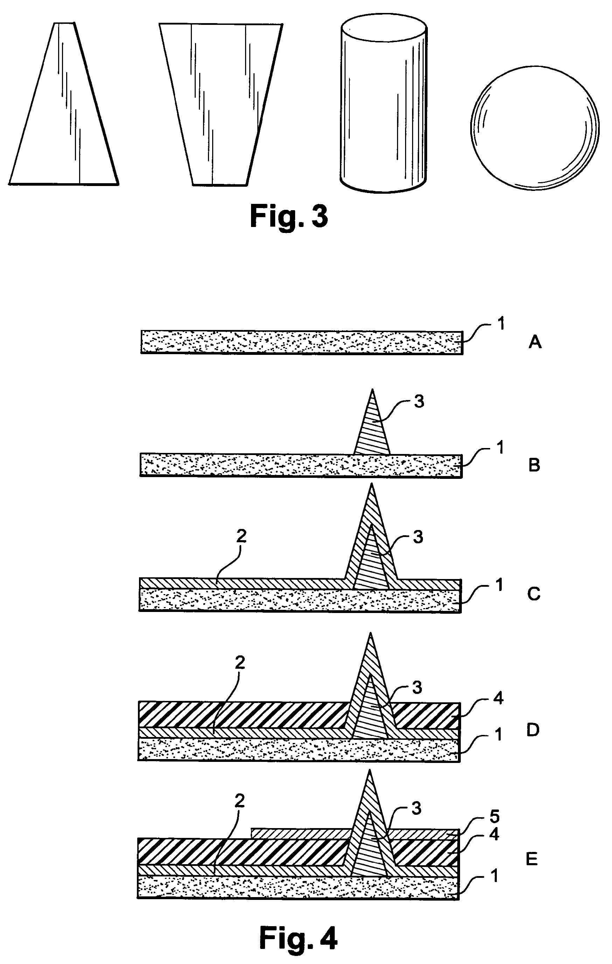

De fait, différentes formes de plot peuvent être envisagées et illustrées à titre exemplatif au sein de la figure 3. Typiquement, ces plots peuvent être de nature tronconique, tronconique inversée, cylindrique, sphérique ou encore parallélépipédique.

En outre, afin de conférer le caractère non mouillable au plot, il peut être envisagé de conférer à celui-ci une rugosité de surface, par exemple par attaque chimique (acide), par attaque physique (plasma) ou encore mécanique (abrasion)....

Ainsi, une surface très rugueuse, en particulier au niveau de la surface ou zone supérieure, du plot, favorise le démouillage.

Ces rugosités peuvent être définies par la grandeur Ra, désignant l'écart moyen ou la moyenne arithmétique des distances séparant les pics et les creux desdites rugosités par rapport à une ligne médiane ou un plan médian, c'est-à-dire par la ligne ou le plan passant par le milieu « moyen » des pics et des creux.

Ainsi, et selon une caractéristique de l'invention, un résultat satisfaisant en termes de non-mouillabilité est obtenu si cette valeur de Ra satisfait à la relation :

$$\frac{e}{2Ra} \leq 3$$

où e désigne l'épaisseur de la couche séparatrice **4**.

Avantageusement, on choisit Ra de telle sorte que ce rapport soit inférieur ou égal à 1.

Selon une variante, ne faisant pas partie de l'invention représentée à l'appui de la figure 4, le plot peut être réalisé avant le dépôt de la couche conductrice inférieure **2**. Pour ce faire (figure 4b), on procède à une déformation de la couche constitutive du substrat ou on rapporte sur ledit substrat un plot 3 non conducteur.

La déformation du substrat peut être réalisée par attaque laser, ainsi que déjà précisé précédemment.

S'il est rapporté sur ledit substrat **1,** un plot en matériau isolant, tel que par exemple en polymère ou en céramique, est alors déposé par exemple par technologie jet d'encre, ou par sérigraphie, par héliographie ou par flexographie.

On procède ensuite (figure 4c) au dépôt de la couche conductrice inférieure **2,** qui recouvre les surfaces latérales du plot afin d'assurer sa fonction conductrice ultérieure. Le dépôt de cette couche conductrice inférieure s'effectue de manière classique par pulvérisation. On peut également procéder au dépôt de cette couche conductrice inférieure par voie liquide qui recouvre alors toute la surface du plot. On utilise par exemple pour ce faire la technique dite du « *spray coating* », ou une technique d'électrodéposition (ou selon l'expression anglo-saxonne « *electroless* »).

On procède ensuite au dépôt de la couche isolante ou semi-conductrice **4,** dont on observe qu'elle s'étend sur une hauteur inférieure à la hauteur totale du plot, et enfin au dépôt de la couche conductrice supérieure **5**. On observe que celle-ci vient en contact avec la couche conductrice recouvrant les flancs du plot **3** et partant, permettant d'aboutir à un via.

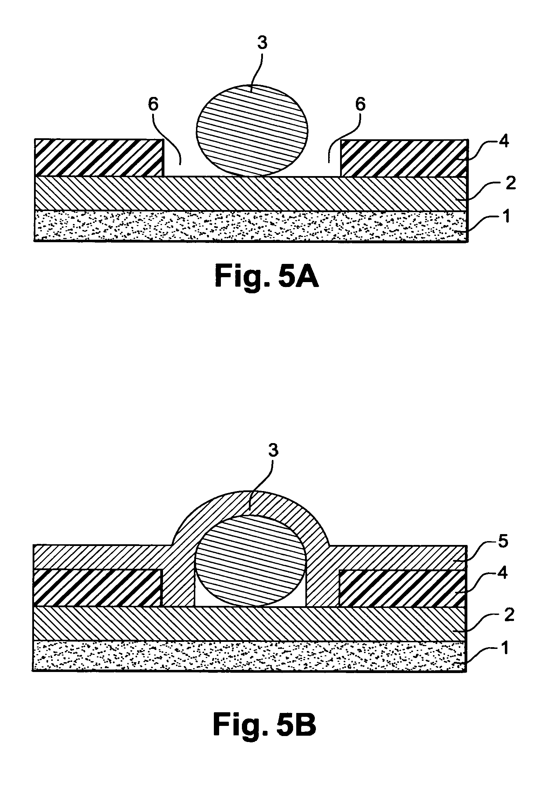

Selon une autre méthode de l'invention, par exemple décrite en relation avec les figures 5a et 5b, on met en oeuvre un plot non conducteur. Ainsi par exemple, on procède au dépôt d'une microbille de verre sur la surface conductrice inférieure **2,** par exemple en mettant en oeuvre la technologie jet d'encre. Cette microbille présente typiquement un diamètre voisin de un micromètre adapté pour une épaisseur de la couche isolante ou en matériau semi-conducteur **4** d'environ 400 nanomètres.

Cette microbille **3** s'avère partiellement démouillante avec un matériau tel que le polyvinyle phénol constitutif de la couche isolante **4.** Il se crée de fait de part et d'autre de la bille 3 une zone **6** dépourvue de matériau isolant lorsque la couche dudit matériau a été déposée.

Lorsque l'on procède au dépôt de la couche conductrice supérieure **5,** celle-ci vient combler partiellement la zone **6** périphérique du plot, exempte de matériau isolant, et vient en contact avec la couche conductrice inférieure **2,** constituant ainsi un via pour la structure ainsi obtenue.

Bien évidemment, plus faible sera l'affinité chimique entre la couche de matériau isolant ou semi-conductrice à déposer et le plot, plus efficace sera le démouillage réalisé autour dudit plot. De fait, afin de favoriser le démouillage de la solution constitutive de la couche séparatrice **4** sur le plot, il est possible de modifier chimiquement la surface dudit plot. A cet effet, on revêt, par exemple par trempage ou par dépôt en phase vapeur, ladite surface de SAM (acronyme de l'expression anglo-saxonne « *Self Assembled Monolayer* » pour couche auto-assemblée) non mouillable par la solution constitutive de la couche séparatrice **4.** On peut ainsi mettre en oeuvre des SAM présentant un groupement thiol (-SH) et un groupement hydrophobe (type alkyl, alkylhalogéné, benzyl,....). Le groupement thiol permet de créer une liaison chimique forte avec les métaux (Au, Ag,...) susceptibles de constituer le plot, et les groupements hydrophobes favorisent le démouillage.

Si dans l'exemple décrit, le plot est non conducteur, cette méthode particulière peut également fonctionner avec un plot conducteur.

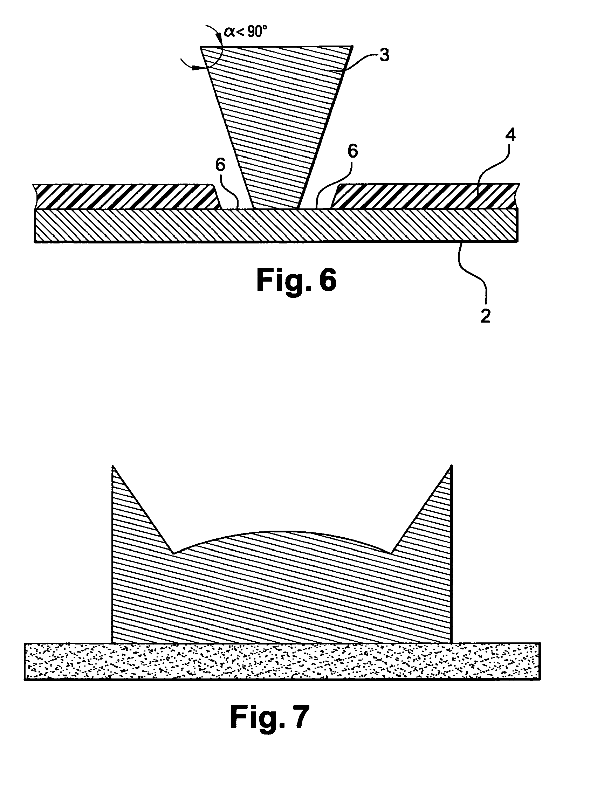

On a représenté, en relation avec la figure 6, la mise en oeuvre d'un plot tronconique inversé susceptible d'être mis en place en lieu et place de la sphère ou microbille des figures 5a et 5b. Dans ce cas, l'angle α tel que défini précédemment, est inférieur à 90°. Il se définit de la même manière une zone de non mouillabilité **6** à la périphérie de la petite base du plot au contact avec la couche conductrice inférieure **2.**

Lorsque le plot est réalisé en utilisant la technologie du jet d'encre, une ou plusieurs gouttes peuvent être déposées successivement au même endroit afin d'aboutir aux caractéristiques géométriques requises, notamment afin d'aboutir à la hauteur suffisante du plot au regard de l'épaisseur respective de la couche conductrice inférieure et de la couche isolante ou semi-conductrice. Ainsi, la hauteur du plot dépend du nombre de gouttes déposées, de l'épaisseur de chacune des gouttes et du temps d'attente entre le dépôt de deux gouttes consécutives. Au surplus, le plot peut être orienté d'un angle variable par rapport au substrat.

La mise en oeuvre de cette technologie du jet d'encre peut conduire à l'effet bien connu de « coffee stain » tel qu'illustré sur la figure 7. Ce phénomène résulte de la différence d'évaporation entre le centre et les bords de la goutte, générant un gradient de concentration qui pousse le soluté vers les bords, créant ainsi une surépaisseur. Cette surépaisseur peut, en raison de sa non uniformité, engendrer des problèmes, et par exemple des courts-circuits entre les couches. Cet effet est donc en général à éviter. Mais dans le cadre de l'invention, en contrôlant cet effet, on peut jouer sur la topologie du flanc du plot, et ainsi favoriser la non-mouillabilité du plot avec la couche en matériau isolant ou semi-conducteur, permettant ainsi de garantir le caractère conducteur du plot avec la couche conductrice supérieure.

On conçoit tout l'intérêt de la présente invention qui, en jouant sur la non-mouillabilité d'un plot, permet de faire la jonction entre deux couches conductrices en passant à travers une couche isolante ou semi-conductrice, simplifiant les techniques de fabrication, notamment des composants électroniques organiques ou inorganiques, tels que les transistors à effet de champ, mais également des microsystèmes pour la biologie, des antennes, des micro batteries, des piles à combustible, etc...

**Revendications**

1. Procédé pour réaliser une interconnexion électrique entre deux couches conductrices (2, 5) séparées par au moins une couche isolante ou semi-conductrice (4), dénommée couche séparatrice, comportant : réaliser un plot (3), préalablement à la réalisation ou au dépôt de la couche séparatrice (4), ledit plot s'étendant au moins entre la couche conductrice inférieure (2) et le voisinage de la couche conductrice supérieure (5), le matériau conducteur constitutif dudit plot, à tout le moins de sa surface externe, étant choisi pour présenter une tension de surface telle à l'état solide, que le rapport des tensions de surface, respectivement dudit matériau à l'état solide et de la couche séparatrice à l'état liquide est inférieur ou égale à 7, **caractérisé en ce que** ledit plot étant obtenu par déformation de la couche conductrice inférieure (2)

2. Procédé selon la revendication 1, **caractérisé en ce que** ledit rapport des tensions de surface, respectivement dudit matériau à l'état solide et de la couche séparatrice à l'état liquide est inférieur ou égale à 1.

3. Procédé selon l'une des revendications 1 et 2, **caractérisé en ce que** la hauteur du plot (3) est supérieure à l'épaisseur de la couche séparatrice (4).

4. Procédé selon l'une des revendications 1 et 2, **caractérisé en ce que** la hauteur du plot (3) est inférieure à l'épaisseur de la couche séparatrice (4).

5. Procédé selon l'une des revendications 1 à 4, **caractérisé en ce que** l'inclinaison de l'orientation des flancs du plot (3) par rapport à l'horizontale est comprise entre 45 et 135°.

**6.** Procédé selon l'une des revendications 1 à 5, *caractérisé* **en ce que** le plot (3) présente une forme choisie dans le groupe comprenant le cône, le tronc de cône, le tronc de cône inversé, le cylindre, la sphère et le parallélépipède.

**7.** Procédé selon l'une des revendications 1 à 6, *caractérisé* **en ce que** le plot (3) présente des rugosités de surface, dont les caractéristiques dimensionnelles répondent à la relation $\dfrac{e}{2Ra} \leq 3$, où Ra désigne l'écart moyen ou la moyenne arithmétique des distances séparant les pics et les creux desdites rugosités par rapport à une ligne médiane et où e désigne l'épaisseur de la couche séparatrice (4).

**8.** Procédé selon la revendication 7, *caractérisé* **en ce que** les caractéristiques dimensionnelles de rugosités de surface du plot (3) répondent à la relation $\dfrac{e}{2Ra} \leq 1$.

**9.** Procédé selon l'une des revendications 1 et 2, *caractérisé* **en ce que** la déformation de la première couche conductrice inférieure (2) constitutive du plot (3) est obtenue par attaque laser.

**10.** Procédé pour réaliser une interconnexion électrique entre deux couches conductrices (2, 5) séparées par au moins une couche isolante ou semi-conductrice (4), dénommée couche séparatrice, comportant :

• réaliser un plot (3), préalablement à la réalisation ou au dépôt de la couche séparatrice (4), s'étendant au moins entre la couche conductrice inférieure (2) et le voisinage de la couche conductrice supérieure (5), plot dont le matériau constitutif, à tout le moins de sa surface externe, est choisi pour présenter une tension de surface telle à l'état solide, que le rapport des tensions de surface, respectivement dudit matériau à l'état solide et de la couche séparatrice à l'état liquide est inférieur ou égale à 7,
• **caractérisé en ce que** le plot (3) est réalisé en un matériau isolant, déposé sur la couche conductrice inférieure (2), et définissant à sa périphérie une zone non mouillable (6) vis à vis du matériau constitutif de la couche séparatrice (4) déposée subséquemment à la couche conductrice inférieure (2),
• et **en ce que** l'on dépose subséquemment à la couche séparatrice (4) la couche conductrice supérieure (5), qui en outre, comble la zone non mouillante (6) définie autour du plot (3), assurant ainsi la conduction électrique entre la couche conductrice inférieure (2) et la couche conductrice supérieure (5).

**11.** Procédé selon l'une des revendications 1 à 10, *caractérisé* **en ce que** la surface externe du plot est modifiée chimiquement par revêtement d'une couche auto-assemblée (SAM - « self assembled monolayer ») non mouillable par la couche séparatrice (4) lorsque celle-ci est encore à l'état liquide.

**12.** Procédé selon la revendication 11, *caractérisé* **en ce que** les couches auto-assemblées (SAM - « self assembled monolayer ») présentent un groupement thiol (-SH) et un groupement hydrophobe (type alkyl, alkylhalogéné, benzyl,....).

**13.** Procédé selon l'une des revendications 1 à 8, *caractérisé* **en ce que** la surface externe du plot est modifiée physiquement par attaque plasma.

**Patentansprüche**

**1.** Verfahren zum Herstellen einer elektrischen Verbindung zwischen zwei leitenden Schichten (2, 5), die durch mindestens eine isolierende oder halbleitende Schicht (4), Trennschicht genannt, getrennt sind, umfassend: Herstellen eines Kontaktstücks (3) vor der Herstellung oder Abscheidung der Trennschicht (4), wobei sich das Kontaktstück zumindest zwischen der unteren leitenden Schicht (2) und der Nachbarschaft der oberen leitenden Schicht (5) erstreckt, wobei das leitende Material, welches das Kontaktstück, und zwar zumindest seine Außenoberfläche ausmacht, so gewählt ist, dass es eine Oberflächenspannung aufweist, die im festen Zustand dergestalt ist, dass das Verhältnis der Oberflächenspannungen des Materials im festen Zustand und der Trennschicht im flüssigen Zustand jeweils kleiner oder gleich 7 ist, **dadurch gekennzeichnet, dass** das Kontaktstück durch Verformung der unteren leitenden Schicht (2) erhalten wird.

**2.** Verfahren nach Anspruch 1, **dadurch gekennzeichnet, dass** das Verhältnis der Oberflächenspannungen des Materials im festen Zustand und der Trennschicht im flüssigen Zustand jeweils kleiner oder gleich 1 ist.

**3.** Verfahren nach einem der Ansprüche 1 und 2, **dadurch gekennzeichnet, dass** die Höhe des Kontaktstücks (3) größer ist als die Dicke der Trennschicht (4).

**4.** Verfahren nach einem der Ansprüche 1 und 2, **dadurch gekennzeichnet, dass** die Höhe des Kontaktstücks (3) kleiner ist als die Dicke der Trennschicht (4).

**5.** Verfahren nach einem der Ansprüche 1 bis 4, **dadurch gekennzeichnet, dass** die Neigung der Ausrichtung der Flanken des Kontaktstücks (3) in Bezug auf die Horizontale zwischen 45 und 135° beträgt.

**6.** Verfahren nach einem der Ansprüche 1 bis 5, **dadurch gekennzeichnet, dass** das Kontaktstück (3) eine Form aufweist, die aus der Gruppe ausgewählt ist, die den Kegel, den Kegelstumpf, den umgekehrten Kegelstumpf, den Zylinder, die Kugel und den Quader umfasst.

**7.** Verfahren nach einem der Ansprüche 1 bis 6, **dadurch gekennzeichnet, dass** das Kontaktstück (3) Oberflächenunebenheiten aufweist, deren Maßeigenschaften das Verhältnis $\frac{e}{2Ra} \leq 3$ erfüllen, worin Ra den mittleren Abstand oder das arithmetische Mittel der Abstände bezeichnet, welche die Spitzen und Täler der Unebenheiten in Bezug auf eine Mittellinie trennen, und worin e die Dicke der Trennschicht (4) bezeichnet.

**8.** Verfahren nach Anspruch 7, **dadurch gekennzeichnet, dass** die Maßeigenschaften der Oberflächenunebenheiten des Kontaktstücks (3) das Verhältnis $\frac{e}{2Ra} \leq 1$ erfüllen.

**9.** Verfahren nach einem der Ansprüche 1 und 2, **dadurch gekennzeichnet, dass** die Verformung der ersten, unteren leitenden Schicht (2), welche das Kontaktstück (3) ausmacht, durch Laserbeaufschlagung erzielt wird.

**10.** Verfahren zum Herstellen einer elektrischen Verbindung zwischen zwei leitenden Schichten (2, 5), die durch mindestens eine isolierende oder halbleitende Schicht (4), Trennschicht genannt, getrennt sind, umfassend:

　　• Herstellen eines Kontaktstücks (3) vor der Herstellung oder Abscheidung der Trennschicht (4), das sich zumindest zwischen der unteren leitenden Schicht (2) und der Nachbarschaft der oberen leitenden Schicht (5) erstreckt, wobei das Material, welches das Kontaktstück, und zwar zumindest seine Außenoberfläche ausmacht, so gewählt ist, dass es eine Oberflächenspannung aufweist, die im festen Zustand dergestalt ist, dass das Verhältnis der Oberflächenspannungen des Materials im festen Zustand und der Trennschicht im flüssigen Zustand jeweils kleiner oder gleich 7 ist,
　　• **dadurch gekennzeichnet, dass** das Kontaktstück (3) aus einem auf der unteren leitenden Schicht (2) abgeschiedenen isolierenden Material hergestellt wird und an deren Umfang eine Zone (6) bildet, die gegenüber dem Material, das die Trennschicht (4) ausmacht, die nachfolgend auf die untere leitende Schicht (2) abgeschieden wird, nicht benetzbar ist,
　　• und dass nachfolgend auf die Trennschicht (4), die obere leitende Schicht (5) abgeschieden wird, die außerdem die um das Kontaktstück (3) gebildete, nicht benetzbare Zone (6) füllt, wodurch die elektrische Leitung zwischen der unteren leitenden Schicht (2) und der oberen leitenden Schicht (5) sichergestellt wird.

**11.** Verfahren nach einem der Ansprüche 1 bis 10, **dadurch gekennzeichnet, dass** die Außenoberfläche des Kontaktstücks durch Überziehen mit einer selbstaggregierten Monoschicht (SAM - "self-assembled monolayer") chemisch modifiziert wird, die durch die Trennschicht (4) nicht benetzbar ist, wenn sich diese noch im flüssigen Zustand befindet.

**12.** Verfahren nach einem der Anspruch 11, **dadurch gekennzeichnet, dass** die selbstaggregierten Monoschichten (SAM - "self-assembled monolayer") eine Thiolgruppe (-SH) und eine hydrophobe Gruppe (des Typs Alkyl, halogenhaltiges Alkyl, Benzyl, usw.) aufweisen.

**13.** Verfahren nach einem der Ansprüche 1 bis 8, **dadurch gekennzeichnet, dass** die Außenoberfläche des Kontaktstücks durch Laserbeaufschlagung physikalisch modifiziert wird.

**Claims**

**1.** A method for making an electric interconnection between two conducting layers (2, 5) separated by at least one insulation or semi-conducting layer (4), known as a separating layer, comprising forming a stud (3) prior to the making or deposition of the separating layer (4), extending at least between the lower conducting layer (2) and the vicinity of the upper conducting layer (5), wherein the conducting material of the stud, and at least of the external surface thereof, is chosen to provide such surface tension in the solid state, that the ratio of the surface tensions, of said material in the solid state to the separating layer in the liquid state respectively, is less than or equal to 7, **characterized in that** the stud (3) is formed by deformation of the first lower conducting layer (2).

**2.** The method as claimed in claim 1, **characterized in that** said surface tension ratio, of said material in the solid state to the separating layer in the liquid state respectively, is less than or equal to 1.

**3.** The method as claimed in one of claims 1 and 2, *characterized* in that the height of the stud (3) is greater than the thickness of the separating layer (4).

**4.** The method as claimed in one of claims 1 and 2, *characterized* in that the height of the stud (3) is less than the thickness of the separating layer (4).

**5.** The method as claimed in one of claims 1 to 4, *characterized* in that the directional pitch of the sides of the stud (3) relative to the horizontal is between 45 and 135°.

**6.** The method as claimed in one of claims 1 to 5, *characterized* in that the stud (3) has a shape chosen from the group that includes the cone, the truncated cone, the inverted truncated cone, the cylinder, the sphere and the parallelepiped.

**7.** The method as claimed in one of claims 1 to 6, *characterized* in that the stud (3) has surface rough areas, whereof the dimensional characteristics fulfil the relationship $\dfrac{e}{2Ra} \leq 3$, where Ra denotes the mean deviation or arithmetic mean of the distances separating the peaks and the troughs of said rough area relative to a median line and where e denotes the thickness of the separating layer (4).

**8.** The method as claimed in claim 7, *characterized* in that the dimensional characteristics of surface rough areas of the stud (3) fulfil the relationship $\dfrac{e}{2Ra} \leq 1$.

**9.** The method as claimed in one of claims 1 and 2, *characterized* in that the stud (3) is obtained by deformation of the first lower conducting layer (2) by laser attack.

**10.** A method for making an electric interconnection between two conducting layers (2, 5) separated by at least one insulation or semi-conducting layer (4), known as a separating layer, comprising forming a stud (3) prior to the making or deposition of the separating layer (4), extending at least between the lower conducting layer (2) and the vicinity of the upper conducting layer (5), wherein the constituent material of the stud, and at least of the external surface thereof, is chosen to provide such surface tension in the solid state, that the ratio of the surface tensions, of said material in the solid state to the separating layer in the liquid state respectively, is less than or equal to 7, *characterized :*

• **in that** the stud (3) is made out of an insulation material, deposited on the lower conducting layer (2), and defining at the periphery thereof a non-wettable zone (6) relative to the constituent material of the separating layer (4), subsequently deposited on the first lower conducting layer (2) ;
• and **in that** electrical conduction between the lower conducting layer (2) and the upper conducting layer (5) results from the subsequent deposition of said upper conducting layer (5), which then fills the non-wetting zone (6) defined around the stud (3).

**11.** The method as claimed in one of claims 1 to 10, *characterized* in that the external surface of the stud is chemically modified by coating with a layer of SAM (self-assembled monoilayer) non-wettable by the separating layer (4) when the latter is still in the liquid state.

**12.** The method as claimed in claim 11, *characterized* in that the SAMs have a thiol group (-SH) and a hydrophobic group (of the alkyl, alkylhalogenated, benzyl type, etc.).

**13.** The method as claimed in one of claims 1 to 8, *characterized* in that the external surface of the stud is physically modified by plasma attack.

**Fig. 1**

**Fig. 2**

**Fig. 3**

**Fig. 4**

**Fig. 5A**

**Fig. 5B**

$\alpha < 90°$

**Fig. 6**

**Fig. 7**

**EP 2 223 581 B1**

## RÉFÉRENCES CITÉES DANS LA DESCRIPTION

**Documents brevets cités dans la description**

- US 2005277279 A